# EUROPÄISCHE PATENTANMELDUNG

(11) **EP 0 867 535 A2**
(43) Veröffentlichungstag der Anmeldung: **30.09.1998**
(21) Anmeldenummer: 98104746.7
(22) Anmeldetag: 17.03.1998
(51) Int. Cl.: C30B 15/30

(54) **Drehkopf für Kristallziehanlagen für die Durchführung des Czochralski-Prozesses**

(30) Priorität: 24.03.1997 US 826084
(71) Anmelder: Balzers und Leybold Deutschland Holding AG, 63450 Hanau (DE)
(72) Erfinder: Schulmann, Winfried, 63801 Kleinostheim (DE); Thimm, Franz, 63755 Alzenau (DE); Kaiser, Helmut, Dr., 63486 Bruchköbel (DE)

(57) **Zusammenfassung**

Ein Drehkopf (11) für Kristallziehanlagen (1) nach Czochralski besitzt ein um eine senkrechte Drehachse (A-A') drehbares Gehäuse (7) mit einer senkrechten Durchführungsöffnung (25) für ein aufwickelbares Zugorgan (13) und ein Antriebsaggregat (23) für den Antrieb einer unter einem Winkel α > 0° zu einer waagerechten Bezugsebene (B-B') verlaufenden Welle (22). Der Winkel α beträgt ca. 0,5° bis 5°. Auf dieser Welle (22) ist verdrehfest, aber axial verschiebbar eine Wickeltrommel (15) mit einer schraubenlinienförmigen Wickelnut (29) für das Zugorgan gelagert. Zur Vermeidung von Abrieb und Kontamination und zur genauen Führung des Zugorgans (13) ist auf der Welle (22) an einer von der senkrechten Drehachse (A-A') entfernten Stelle ein mit de Welle (22) drehbares, schraubenlinienförmiges Führungselement (30) gleicher Steigung wie die Wikkelnut angeordnet. Das Führungselement (30) wirkt derart mit einer Führungsmutter (31) zusammen, daß der tangential von der Wickeltrommel (15) wegweisende Teil des Zugorgans (13) unmittelbar in der senkrechten Drehachse (A-A') geführt ist. Dabei ist das schraubenlinienförmige Führungselement (30) als Führungsnut ausgebildet und die Führungsmutter (31) wirkt über umlaufende Kugeln (32) mit der Führungsnut zusammen.

## Beschreibung

Die Erfindung betrifft einen Drehkopf für Kristallziehanlagen für die Durchführung des Czochralski-Prozesses mit
a) einem um eine senkrechte Drehachse drehbaren Gehäuse, das im Bereich dieser Drehachse eine senkrechte Durchführungsöffnung für ein aufwikkelbares Zugorgan besitzt,
b) einer antreibbaren Welle auf der verdrehfest, aber axial verschiebbar eine Wickeltrommel mit einer schraubenlinienförmigen Wickelnut für die Aufnahme des Zugorgans gelagert ist und
c) einer die axiale Verschiebung der Wickeltrommel bewirkenden, die gleiche Steigung wie die Wikkelnut aufweisenden Führungseinrichtung, die an einer von der senkrechten Drehachse entfernten Stelle angeordnet ist und durch die der auf die Wickeltrommel aufzuwickelnde Teil des Zugorgans mittels der die Wickelnut in der senkrechten Drehachse geführt ist.

Derartige Drehköpfe, die bei Verwendung eines Seils als Zugorgan auch als Seildrehköpfe bezeichnet werden, sind bekannt. Sie dienen dazu, einen nach der Czochralski-Methode gebildeten Kristall aus der in einem Schmelztiegel befindlichen Schmelze nach oben zu ziehen und hierbei gleichzeitig dem gezogenen Kristall eine Drehbewegung um seine Längsachse zu überlagern. Es ist hierbei eine zwingende Voraussetzung, daß sowohl die Hub- als auch die Drehbewegung des Kristalls möglichst gleichförmig, insbesondere aber vollständig ruckfrei durchgeführt werden. Da in dem Drehkopf üblicherweise der gleiche Druck herrscht wie in der Kristallziehanlage, nach Möglichkeit aber keine kondensationsfähigen Stoffe aus der Kristallziehanlage in den Drehkopf gelangen sollen, ist die Durchführungsöffnung in der Bezugsplattform relativ eng ausgebildet. Das Zugorgan muß hierbei möglichst koaxial in der Durchführungsöffnung geführt werden. Da das Zugorgan auf der Wikkeltrommel in einer schraubenlinienförmigen Bahn aufgewickelt wird, muß die Wickeltrommel in Richtung ihrer Längsachse so nachgeführt werden, daß die Achse des Zugorgans stets mit der Achse der Durchführungsöffnung zusammenfällt. In der Nähe der Wickeltrommel verläuft das Zugorgan im wesentlichen tangential zur Oberfläche der Wickeltrommel.

Mit einem derartigen Drehkopf, der durch die DE 43 29 283 C2 bekannt ist, wurde bereits erfolgreich die Aufgabe gelöst, eine ruckfreie rotatorische und axiale Bewegung der Wickeltrommel zu ermöglichen und die Bildung von Abrieb aus Kondensaten aus Halbleitermaterial und Material des Zugorgans und der Führungseinrichtung drastisch zu verringern. Dieser Abrieb könnte durch die Durchführungsöffnung in die darunter befindliche Kristallziehanlage fallen und den Kristallziehprozeß nachhaltig stören.

Bei der bekannten Lösung verläuft die Achse von Welle und Wickeltrommel waagrecht, bzw. sie wird in einer waagrechten Ebene exzentrisch um die senkrechte Drehachse gedreht. Dadurch wird jedoch das Zugorgan an der Stelle seines Auflaufens oder Ablaufens auf die Wickeltrommel scharfkantig und quer zur Achse der Wickeltrommel gebogen, und das Zugorgan scheuert an einer Flanke der Wickelnut. Hierdurch wird nicht nur das unter erheblicher Zugspannung und Temperaturbelastung stehende Zugorgan mechanisch stark belastet, sondern es wird auch durch die Reibung zu Vibrationen angeregt, ähnlich wie beim Anstreichen einer Violinsaite durch den Bogen, so daß der Ziehprozeß gestört wird, der äußerst empfindlich gegenüber mechanischen Erschütterungen ist.

Weiterhin wird dadurch partikelförmiger Abrieb von Kondensation auf der Wickeltrommel und auf dem Zugorgan und von Material des Zugorgans und der Wikkeltrommel erzeugt, und schließlich entstehen durch die Reibung Unregelmäßigkeiten beim Ab- und insbesondere beim Aufwickeln des Zugorgans, d. h. beim Kristallziehen.

Der in der DE 43 29 283 C2 genannte Stand der Technik liegt vom Erfindungsgegenstand noch weiter ab.

Bei der DE 31 16 916 C2 besteht die Führungseinrichtung für die axiale Verschiebung der Wickeltrommel, die gleichfalls auf einer waagrechten Welle gelagert ist, aus einer tonnenförmigen Andruckrolle, die oberhalb der Durchführungsöffnung angeordnet ist und das Führungsorgan, ein Drahtseil, in die Führungsnut preßt. Durch die Seilquetschung und Querkräfte sowie durch den Seilknick an der Einlaufstelle in die schräg zur Drehachse stehende Wickelnut und auf deren Kante entsteht Abrieb von Kondensat und Metall unmittelbar über der Durchführungsöffnung. Die Wickeltrommel wird dabei unmittelbar durch das Zugorgan geführt und nur die Andruckrolle, d.h. das Zugorgan übernimmt die axiale Trommelführung und nicht umgekehrt, so daß die Seilführung ungenau und auch nicht völlig ruck- und vibrationsfrei ist.

Durch die EP 0 437 775 A1 ist ein Drehkopf bekannt, bei dem die Wickeltrommel, die gleichfalls um eine waagrechte Achse drehbar ist, durch ein Führungsgewinde in waagrechter Richtung verschiebbar ist, wobei die Steigung des aufgewickelten Zugorgans (Seil) durch die Steigung des Führungsgewindes bestimmt wird. Die Wickeltrommel selbst besitzt jedoch für die Seilablage eine Zylinderfläche, also keine Wickelnut, so daß für die gleichmäßige Ablage des Seils eine oberhalb der Wickeltrommel ortsfest gelagerte Führungsrolle vorgesehen ist, deren Auflaufstelle für das Seil sich ständig oberhalb der Durchführungsöffnung befindet. Erst von dieser Führungsrolle wird das Seil bzw. Zugorgan an die Wikkeltrommel übergeben. Die Führungsrolle ist mithin dasjenige Element, das den senkrechten Laufweg des Zugorgans bestimmt. Ferner sind der Führungsrolle entweder Führungsstifte, Führungskörper oder eine weitere Führungsrolle zugeordnet, die für weiteren Abrieb sorgen, so daß zur Vermeidung der Verunreinigung der Schmelze und des Einkristalls mit Metallen die betreffenden Teile aus Kunststoff gefertigt sein sollen. Dadurch wird jedoch die Freisetzung von Kondensatpartikeln nicht verhindert.

Der Umfang der Führungsrolle ist am gleichen Ort ständig einer Kondensation von Dampf aus der Durchführungsöffnung ausgesetzt. Ferner wird durch den ungleichmäßigen Abrieb vom Zugseil eine rauhe Seiloberfläche erzeugt, die einem gleichförmigen Seileinzug entgegenwirkt.

Der Erfindung liegt daher die Aufgabe zugrunde, einen Drehkopf der eingangs beschriebenen Gattung dahingehend zu verbessern, daß das Zugorgan nicht mehr scharfkantig gebogen, die Reibung zwischen dem Zugorgan und der Wickeltrommel und damit die Bildung von partikelförmigem Abrieb minimiert und die Gleichmäßigkeit des Ablaufs und vor allem des Auflaufs des Zugorgans auf die Wickeltrommel verbessert werden.

Die Lösung der gestellten Aufgabe erfolgt bei dem eingangs angegebenen Drehkopf erfindungsgemäß dadurch, daß die Achse der Welle und die Wickeltrommel unter einem solchen Winkel α zu einer waagrechten Bezugsebene verläuft, daß das Zugorgan in die Wickelnut in Richtung einer Schraubenlinie einläuft, die den Verlauf der Wickelnut bestimmt.

Der Einlauf des Zugorgans in die Wickelnut erfolgt also nicht mehr tangential bzw. rechtwinklig zur Achse der Wickeltrommel, sondern tangential zu einer Stelle der Schraubenlinie der Wickelnut. Die Tangente des Zugorgans im Auf- bzw. Ablaufpunkt der Wickeltrommel verläuft erfindungsgemäß koaxial zum abgewickelten Teil des Zugorgans. Die schrägstehende Achse von Welle und Wickeltrommel rotiert im Betrieb in einer Doppelkegelfläche, deren Achse exzentrisch zur senkrechten Drehachse verläuft. Die Achse führt also gewissermaßen eine Taumelbewegung aus, die aber frei von Unwuchten ist. Dafür verläuft jetzt der senkrecht nach unten hängende Teil des Zugorgans tangential zum ersten Berührungspunkt der Wickelnut. Insbesondere kann das Zugorgan nicht mehr - wie beim Stand der Technik - auf eine seitliche Kante der Wickelnut auflaufen.

Hierdurch werden die folgenden zusätzlichen Vorteile erreicht: Das Zugorgan wird an der Stelle Seines Auflaufs oder Ablaufs auf die Wickeltrommel nicht mehr scharfkantig und quer zur Achse der Wickeltrommel gebogen, und das Zugorgan scheuert nicht mehr an einer Flanke der Wickelnut. Hierdurch wird nicht nur das unter erheblicher Zugspannung und Temperaturbelastung stehende Zugorgan mechanisch entlastet, sondern es wird auch nicht mehr durch die trockene Reibung zu Vibrationen angeregt, so daß der Ziehprozeß nicht mehr gestört wird, der äußerst empfindlich gegenüber mechanischen Erschütterungen ist.

Weiterhin wird dadurch partikelförmiger Abrieb von Kondensaten auf der Wickeltrommel und auf dem Zugorgan und von Material des Zugorgans und der Wikkeltrommel minimiert, und schließlich entfallen durch die Reibung bedingte Unregelmäßigkeiten beim Ab- und insbesondere beim Aufwickeln des Zugorgans, d.h. beim Kristallziehen.

Es ist dabei besonders vorteilhaft, wenn, wie im Anspruch 2 angegeben, der Winkel α maximal 10°, vorzugsweise zwischen 0,5° und 5° beträgt. Während es theoretisch möglich ist, die Schrägstellung der Welle und der Wickeltrommel innerhalb eines Gehäuses vorzunehmen, dessen Hauptebene waagrecht verläuft, ist es besonders vorteilhaft, wenn das Gehäuse gemäß den Merkmalen des Anspruchs 3 bzw. dessen Hauptebene als solches bzw. solche unter dem Winkel α zu einer waagrechten Bezugsebene ausgerichtet ist. Hierdurch wird vermieden, daß mechanische Teile wie Lagerböcke, Lagerringe, Führungsmuttern etc. unter Winkeln bearbeitet werden müssen, die vom rechten Winkel abweichen, so daß die Fertigung deutlich vereinfacht und verbilligt wird.

Weitere vorteilhafte Ausgestaltungen des Erfindungsgegenstandes ergeben sich aus den übrigen Unteransprüchen.

Die nachstehend beschriebenen schraubenlinienförmigen Führungselemente können in unterschiedlicher Weise gestaltet sein. So ist es möglich, die betreffenden Führungselemente als erhabene Schraubengänge mit gleicher Steigung wie die Wickelnut auszuführen. Die Führungsmutter hat alsdann eine jeweils hierzu komplementäre Form.

Zwei Ausführungsbeispiele des Erfindungsgegenstandes werden nachfolgend anhand der Figuren 1 bis 4 näher erläutert.

Es zeigen:
- Figur 1: einen teilweisen Vertikalschnitt entlang der senkrechten Drehachse A-A' durch eine Kristallziehanlage für die Durchführung der Czochralski-Methode,
- Figur 2: einen vertikalen Axialschnitt entlang der schrägstehenden Achse H-H' durch ein erstes Ausführungsbeispiel eines sogenannten Drehkopfes,
- Figur 3: einen teilweise axialen Vertikalschnitt entlang der schrägstehenden Achse H-H' durch ein zweites Ausführungsbeispiel des Erfindungsgegenstandes und
- Figur 4: einen vertikalen Radialschnitt durch eine Wickeltrommel im Bereich des Endes und der Befestigungsstelle des flexiblen Zugorgans.

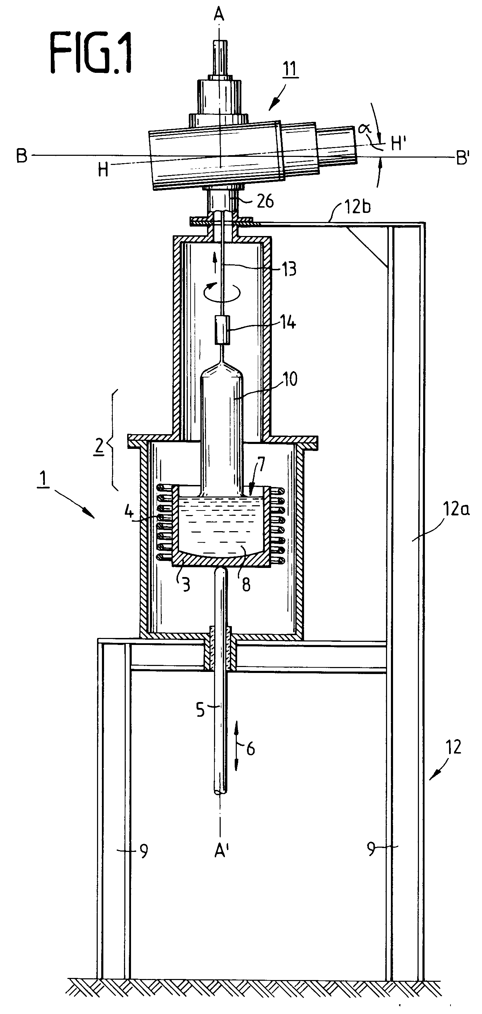

In Figur 1 ist eine Kristallziehanlage für die Durchführung des Verfahrens nach Czochralski dargestellt, zu der eine gasdichte Kammer 2 gehört, die an nicht dargestellte Vakuumpumpen angeschlossen ist. In der Kammer 2 befindet sich ein Schmelztiegel 3, der von einer Induktionsspule 4 umgeben ist, durch die der Inhalt des Schmelztiegels 3 aufgeschmolzen und auf der erforderlichen Temperatur für den Ziehprozeß gehalten wird. Der Schmelztiegel 3 ist über eine Hubstange 5 mit einem nicht dargestellten Vertikalantrieb verbunden, mit der die Hubstange 5 in Richtung des Doppelpfeils 6 auf- und abwärts bewegt werden kann. Dadurch kann die Oberfläche 7 der Schmelze 8 auf einer konstanten Höhe gehalten werden. Die Kammer 2 ist auf einem Traggerüst 9 angeordnet.

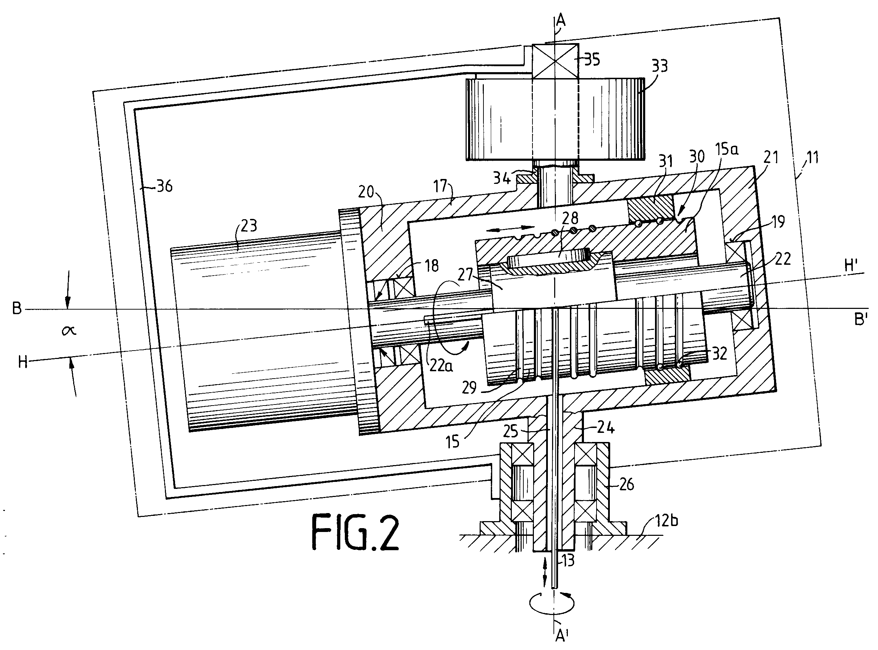

Aus der Schmelze 8 wird ein Kristall 10 mit geregelter Geschwindigkeit nach oben gezogen, wobei dieser Kristall durch einen Drehkopf 11 gleichzeitig in Drehung versetzt wird. Der Drehkopf 11 wird anhand der Figur 2 noch näher erläutert; er ist auf einer Verlängerung 12a einer der Tragstützen 12 des Traggerüstes 9 montiert. Vom Drehkopf 11 führt ein flexibles Zugorgan 13, das im vorliegenden Fall als Zugseil ausgebildet ist, in die Kammer 2. An diesem Zugorgan 13 hängt mittels eines Keimkristallhalters 14 der besagte Kristall 10. Die Schilderung weiterer Einzelheiten erübrigt sich, da mit Ausnahme des Drehkopfes 11 eine derartige Kristallziehanlage zum Stande der Technik gehört.

In Figur 2 ist der Drehkopf 11 in Figur 1 teilweise in zwei senkrechten Ebenen geschnitten dargestellt, die durch die senkrechte Drehachse A-A' und die unter einem Winkel α zu einer waagrechten Bezugsebene B-B' verlaufende Achse H-H' einer Wickeltrommel 15 für das Zugorgan 13 definiert sind. Zum Drehkopf 11 gehört ein Gehäuse 17, das die Wickeltrommel 15 mit Abstand umgibt. Das Gehäuse 17 besitzt zwei Lagerstellen 18 und 19 in den Stirnwänden 20 und 21 des Gehäuses 17. In diesen Lagerstellen 18 und 19 ist eine Welle 22 gelagert, die an ihrem einen Ende durch ein elektrisches Antriebsaggregat 23 angetrieben wird, zu dem hier nicht dargestellte Untersetzungsgetriebe gehören.

Das Gehäuse 17 ist mit einer senkrechten Hohlwelle 24 ausgestattet, die die Drehachse A-A' definiert und eine zu dieser Achse konzentrische Durchführungsöffnung 25 besitzt, die auch durch die Unterseite des Gehäuses 17 hindurchgeht. Durch diese Durchführungsöffnung 25 ist das Zugorgan 13 hindurchgeführt. Die Hohlwelle 24 ist mittels zweier nur angedeuteter Wälzlager in einem Lagergehäuse 26 gelagert, das wiederum auf dem in Figur 1 gezeigten Ausleger 12b der Tragstütze 12 befestigt ist. Das Lagergehäuse 26 ist gegenüber der Hohlwelle 24 abgedichtet und auch gasdicht mit der Kammer 2 verbunden. Ferner ist auch das Gehäuse 17 gasdicht ausgeführt, so daß sich über die Durchführungsöffnung 25 im Gehäuse 17 der gleiche Druck einstellen kann wie in der Kammer 2. Auch die Achse des Gehäuses 17 verläuft unter dem Winkel α zur waagrechten Bezugsebene B-B'.

Die schrägstehende Welle 22 besitzt auf ihrem Umfang einen Keil 22a, der zur verdrehsicheren Führung der Wickeltrommel 15 dient. Zu diesem Zweck ist die Wickeltrommel 15 mittels einer eingesetzten Kugelbüchse 27 axial beweglich auf der Weile 22 geführt. Weitere Einzelheiten dieser Führung sind Figur 4 zu entnehmen. Die Kugelbüchse 27 ist ihrerseits über eine Passfeder 28 verdrehfest mit der Wickeltrommel 15 verbunden, die auf ihrer Oberfläche mit einer schraubenlinienförmigen Wickelnut 29 für die Aufnahme des Zugorgans 13 versehen ist. Das Zugorgan 13 läuft von unten tangential in die Wikkelnut 29 ein.

Auf der schrägstehenden Welle 22 ist an einer von der senkrechten Drehachse A-A' entfernten Stelle ein mit der Welle 22 drehbares schraubenlinienförmiges Führungselement 30 angeordnet, das die gleiche Steigung wie die Wickelnut 29 besitzt. Dieses Führungselement 30 wirkt in der Weise mit einer Führungsmutter 31 zusammen, daß der tangential von der Wickelnut 29 wegweisende Teil des Zugorgans 13 in der Drehachse A-A' geführt ist.

Im vorliegenden Fall ist das schraubenlinienförmige Führungselement 30 auf der Oberfläche einer Verlängerung 15a der Wickeltrommel 15 angeordnet, und die Führungsmutter 31 ist relativ zum Gehäuse 17 festgelegt, d. h. mit diesem verschraubt. Alternativ ist es möglich, das Gehäuse 17 und die Führungsmutter 31 aus einem Teil auszubilden.

Bei dem Ausführungsbeispiel nach Figur 2 ist das schraubenlinienförmige Führungselement 30 als Führungsnut ausgebildet, und die Führungsmutter 31 wirkt über umlaufende Kugeln 32 mit der Führungsnut zusammen.

Wegen der Identität der Steigungen und der Steigungsrichtung von Wickelnut 29 und Führungselement 30 (Führungsnut) wird die Wickeltrommel 15 nach Maßgabe der Ab- oder Aufwicklung des Zugorgans 13 stets in dem Sinne verschoben, daß die Achse des Zugorgans stets koaxial zur Achse A-A' bzw. zur Durchführungsöffnung 15 verläuft.

Zur Herbeiführung einer Drehbewegung des Gehäuses 17 mit der Wickeltrommel 15 um die Systemachse A-A' befindet sich auf der Oberseite des Gehäuses 17 ein elektrischer Getriebemotor 33 mit einer Hohlwelle 34, die mit dem Gehäuse 17 verbunden ist. Durch die Hohlwelle 34 sind die elektrischen Anschlußleitungen für Regelung und Antrieb der elektrischen Einrichtungen hindurchgeführt, was hier jedoch nicht näher dargestellt ist. Die Verbindung mit äußeren Anschlüssen erfolgt über ein Schleifringsystem 35, das jedoch gleichfalls nur schematisch dargestellt ist. Der stationäre Teil des Getriebemotors 33 ist über einen Bügel 36 mit dem Lagergehäuse 26 verbunden, das sich wieder um gegenüber der Kammer 2 und dem Ausleger 12b im Ruhezustand befindet. Der Bügel 36 ist in der Weise um das Gehäuse 17 mit dem Antriebsaggregat 23 herumgeführt, daß eine freie Beweglichkeit gegeben ist.

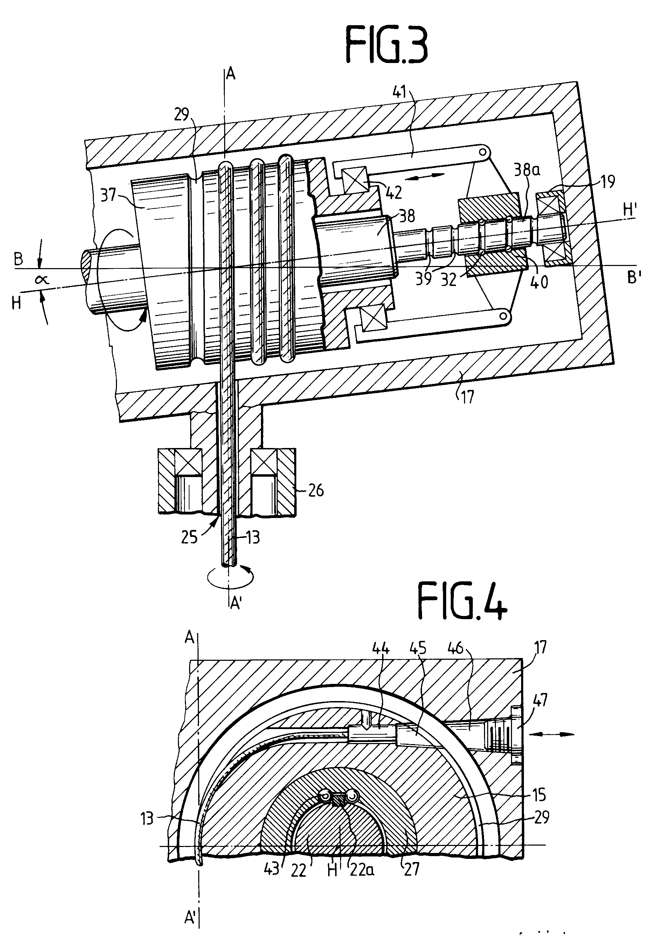

Bei dem Ausführungsbeispiel nach Figur 3 sind gleiche Teile wie in Figur 2 mit gleichen Bezugszeichen versehen, so daß sich Wiederholungen erübrigen. Im vorliegenden Fall ist die Wickeltrommel 37 verkürzt ausgebildet, d. h. sie trägt im wesentlichen nur eine Wickelnut 29. Die waagrechte Weile 38 ist abgesetzt ausgebildet und trägt auf ihrem verjüngten Ende 38a gleichfalls ein schraubenlinienförmiges Führungselement 39, mit dem eine Führungsmutter 40 zusammenwirkt. Diese Führungsmutter 40 ist - durch nicht dargestellte Mittel - zwar gegenüber der Bezugsplattform 16 verdrehfest angeordnet, zugleich aber mit der Wickeltrommel 37 axial verschiebbar. Auch das schraubenlinienförmige Führungselement 39 ist im vorliegenden Fall als Führungsnut ausgebildet, und auch hierbei steht die Führungsmutter 40 über umlaufende Kugeln 32 mit der Führungsnut in Verbindung. Das schraubenlinienförmige Führungselement 39 (Führungsnut) hat auch in diesem Falle die gleiche Steigung und die gleiche Steigungsrichtung wie die Wickelnut 29, so daß auch bei dieser Ausführungsform das Zugorgan 13 stets konzentrisch in der Durchführungsöffnung 25 geführt ist. Die in diesem Fall gegebene Axialbewegung der Führungsmutter 40 wird durch Laschen 41 unter Zwischenschaltung eines Axiallagers 42 auf die Wickeltrommel 37 übertragen. Die Wickeltrommel 37 ist in analoger Weise auf der Welle 38 gelagert, wie dies in Figur 2 dargestellt ist.

Figur 3 läßt den Kern der Erfindung besonders deutlich erkennen: Die Achse H-H' ist um einen solchen Winkel α geneigt, daß der dem Betrachter zugekehrte Teil der Wickelnut 29 an der Stelle, an der die virtuelle Bezugsebene B-B' das Zugorgan 13 schneidet, genau senkrecht verläuft, so daß dieses exakt in Richtung der Schraubenlinie, die die Wickelnut definiert, von unten in diese einläuft. Ein Scheuern oder Reiben des Zugorgans an den Flanken der Wickelnut findet praktisch nicht mehr statt. Das Zugorgan läuft auch nicht mehr auf die eine Flankenkante auf und wird auch nicht mehr in der Zeichenebene mit kleinem Radius gebogen oder geknickt. Das Zugorgan folgt nach dem Aufwickeln lediglich dem großen Krümmungsradius der Wickelnut. Daraus ergibt sich, daß der Winkel α von der Steigung der Wickelnut und von deren Durchmesser abhängt. Dieser Durchmesser wird durch den schraubenlinienförmigen Verlauf der Mittelachse des Zugorgans in der Wikkelnut bestimmt. Praktische Werte für den Winkel α betragen bis 10°.

In Figur 4 ist die schrägstehende Welle 22 gemäß Figur 2 mit ihrem Keil 22a dargestellt, wobei diese Welle 22 unter Zwischenschaltung von Kugeln 43 die bereits beschriebene Kugelbüchse 27 in Umfangsrichtung mitnimmt, in axialer Richtung aber die bereits beschriebene Bewegung zuläßt. Es ist weiterhin dargestellt, daß das Ende des Zugorgans 13 ein im Durchmesser größeres Endstück 44 besitzt, mit dem das Zugorgan 13 in einer etwa tangentialen Bohrung 45 der Wickeltrommel 15 bzw. 37 gehalten ist. In dem Gehäuse 17 befindet sich eine verschließbare Öffnung 46, mit der das Endstück 44 des Zugorgans 13 in eine Fluchtstellung bringbar ist. Die Öffnung 46 ist durch einen Schraubstopfen 47 gasdicht verschlossen. Nach dem Abnehmen des Schraubstopfens 47 läßt sich das Zugorgan 13 durch die Öffnung 46 ins Freie schieben, wo alsdann das Endstück 44 vom Zugorgan 13 gelöst werden kann. Auf diese Weise läßt sich das Zugorgan 13 ohne weitere Demontage aus dem Drehkopf herausnehmen.

Üblicherweise wird das flexible Zugorgan 13 als Stahlseil aus einem temperatur- und korrosionsbeständigen Werkstoff ausgeführt. Es ist jedoch denkbar, als Zugorgan eine feingliedrige Kette oder vergleichbare Mittel zu verwenden.

### Bezugszeichenliste

- 2: Kammer
- 3: Schmelztiegel
- 4: Induktionsspule
- 5: Hubstange
- 6: Doppelpfeil
- 7: Oberfläche
- 8: Schmelze
- 9: Traggerüst
- 10: Kristall
- 11: Drehkopf
- 12: Tragstütze
- 13: Zugorgan
- 14: Keimkristallhalter
- 15: Wickeltrommel
- 17: Gehäuse
- 18: Lagerstelle
- 19: Lagerstelle
- 20: Stirnwand
- 21: Stirnwand
- 22: Welle
- 23: Antriebsaggregat
- 24: Hohlwelle
- 25: Durchführungsöffnung
- 26: Lagergehäuse
- 27: Kugelbüchse
- 28: Passfeder
- 29: Wickelnut
- 30: Führungselement
- 31: Führungsmutter
- 32: Kugel
- 33: Getriebemotor
- 34: Hohlwelle
- 35: Schleifringsystem
- 36: Bügel
- 37: Wickeltrommel
- 38: Welle
- 39: Führungselement
- 40: Führungsmutter
- 41: Lasche
- 42: Axiallager
- 43: Kugel
- 44: Endstück
- 45: Bohrung
- 46: Öffnung
- 47: Schraubstopfen

## Patentansprüche

1. Drehkopf (11) für Kristallziehanlagen (1) für die Durchführung des Czochralski-Prozesses mit
a) einem um eine senkrechte Drehachse (A-A') drehbaren Gehäuse (17), das im Bereich dieser Drehachse eine senkrechte Durchführungsöffnung (25) für ein aufwickelbares Zugorgan (13) besitzt,
b) einer antreibbaren Welle (22,38) auf der verdrehfest, aber axial verschiebbar eine Wickeltrommel (15,37) mit einer schraubenlinienförmigen Wickelnut (29) für die Aufnahme des Zugorgans gelagert ist und
c) einer die axiale Verschiebung der Wickeltrommel (15,37) bewirkenden, die gleiche Steigung wie die Wickelnut aufweisenden Führungseinrichtung, die an einer von der senkrechten Drehachse (A-A') entfernten Stelle angeordnet ist und durch die der auf die Wickeltrommel (15,37) aufzuwickelnde Teil des Zugorgans (13) mittels der die Wickelnut (29) in der senkrechten Drehachse (A-A') geführt ist,
**dadurch gekennzeichnet ,** daß
d) die Achse (H-H') der Welle (22,38) und der Wickeltrommel (15,37) unter einem solchen Winkel α zu einer waagrechten Bezugsebene (B-B') verläuft, daß das Zugorgan (13) in die Wickelnut (29) in Richtung einer Schraubenlinie einläuft, die den Verlauf der Wickelnut (29) bestimmt.

2. Drehkopf nach Anspruch 1, **dadurch gekennzeichnet,** daß der Winkel α maximal 10° beträgt.

3. Drehkopf nach Anspruch 1, **dadurch gekennzeichnet,** daß das Gehäuse (17) als solches unter dem Winkel α zu der waagrechten Bezugsebene (B-B') ausgerichtet ist.

4. Drehkopf nach Anspruch 1, **dadurch gekennzeichnet ,** daß die Führungseinrichtung für die axiale Führung der Wickeltrommel (15,37) auf der Oberfläche einer Verlängerung (15a) der Wickeltrommel (15) angeordnet ist und daß eine Führungsmutter (31) relativ zum Gehäuse (17) festgelegt ist.

5. Drehkopf nach Anspruch 1, **dadurch gekennzeichnet ,** daß die Führungseinrichtung für die axiale Führung der Wickeltrommel (15,37) auf der Oberfläche der Welle (38) angeordnet ist und daß eine Führungsmutter (40) gegenüber dem Gehäuse (17) verdrehfest, aber mit der Wickeltrommel (37) axial verschiebbar angeordnet ist.

6. Drehkopf nach Anspruch 4 oder 5, **dadurch gekennzeichnet,** daß die Führungseinrichtung ein schraubenlinienförmiges Führungselement (30,39) aufweist, das als Führungsnut ausgebildet ist und daß die Führungsmutter (31,40) über umlaufende Kugeln (32) mit der Führungsnut zusammen wirkt.

7. Drehkopf nach Anspruch 1, **dadurch gekennzeichnet ,** daß die Wickeltrommel (15,37) mittels einer eingesetzten Kugelbüchse (22) verdrehfest, aber in Längsrichtung verschiebbar, auf der Welle (22) gelagert ist.

8. Drehkopf nach Anspruch 1, **dadurch gekennzeichnet ,** daß das Ende des Zugorgans (13) ein im Durchmesser größeres Endstück (44) besitzt, mit dem das Zugorgan (13) in einer tangentialen Bohrung (45) in der Wickeltrommel (15,37) gehalten ist, und daß sich in dem Gehäuse (17) eine verschließbare Öffnung (46) befindet, mit der das Endstück (44) des Zugorgans in eine Fluchtstellung bringbar ist.

9. Drehkopf nach Anspruch 1 und/oder 2, **dadurch gekennzeichnet ,** daß der Winkel α zwischen 0,5° und 5° beträgt.
